# FASCICULE DE BREVET EUROPEEN

(11) **EP 3 646 392 B1**
(45) Date de publication et mention de la délivrance du brevet: **03.08.2022**
(21) Numéro de dépôt: 18728411.2
(22) Date de dépôt: 08.06.2018
(51) Int. Cl.: H01L 33/50, G02B 6/122, H01L 25/075, H01L 33/58

(54) **DISPOSITIF OPTOÉLECTRONIQUE**
OPTOELEKTRONISCHE VORRICHTUNG
OPTOELECTRONIC DEVICE

(30) Priorité: 27.06.2017 FR 1755898
(43) Date de publication de la demande: 06.05.2020
(73) Titulaire: Aledia, 38130 Echirolles (FR)
(72) Inventeur: DUPONT, Tiphaine, 38000 Grenoble (FR)
(74) Mandataire: Cabinet Beaumont
(86) Numéro de dépôt international: PCT/EP2018/065136
(87) Numéro de publication internationale: WO 2019/001927

(56) Documents cités:
- TW-B- I 588 984
- US-A1- 2007 025 673
- US-A1- 2007 085 100
- US-A1- 2011 297 975
- US-A1- 2014 001 503

## Description

La présente demande de brevet revendique la priorité de la demande de brevet français FR17/55898.

### Domaine

La présente demande concerne un dispositif optoélectronique, notamment un écran d'affichage ou un dispositif de projection d'images, comprenant des sources électroluminescentes, notamment des diodes électroluminescentes à base de matériaux semiconducteurs, et leurs procédés de fabrication.

### Exposé de l'art antérieur

Un pixel d'une image correspond à l'élément unitaire de l'image affichée par le dispositif optoélectronique. Lorsque le dispositif optoélectronique est un écran d'affichage d'images couleur, il comprend en général pour l'affichage de chaque pixel de l'image au moins trois composants, également appelés sous-pixels d'affichage, qui émettent chacun un rayonnement lumineux sensiblement dans une seule couleur (par exemple, le rouge, le vert et le bleu). La superposition des rayonnements émis par ces trois sous-pixels d'affichage fournit à l'observateur la sensation colorée correspondant au pixel de l'image affichée. Dans ce cas, on appelle pixel d'affichage du dispositif optoélectronique l'ensemble formé par les trois sous-pixels d'affichage utilisés pour l'affichage d'un pixel d'une image.

Il existe des dispositifs optoélectroniques comprenant des sources électroluminescentes, notamment des diodes électroluminescentes à base de matériaux semiconducteurs, et des blocs de matériaux photoluminescents recouvrant au moins certaines des sources électroluminescentes. Chaque bloc photoluminescent est adapté à convertir le rayonnement émis par la source électroluminescente associée, ou premier rayonnement, en un rayonnement à la longueur d'onde souhaitée, ou deuxième rayonnement.

On définit l'efficacité lumineuse d'un dispositif optoélectronique comme le rapport entre le flux lumineux émis par le dispositif optoélectronique vers l'extérieur et la puissance électrique consommée par les sources électroluminescentes du dispositif optoélectronique.

Un inconvénient des dispositifs optoélectroniques décrits précédemment est qu'une partie du rayonnement émis par les sources électroluminescentes n'est généralement pas convertie par les blocs photoluminescents associés et doit généralement être bloquée par un filtre recouvrant les blocs photoluminescents. Il n'est toutefois pas souhaitable d'augmenter de façon excessive l'épaisseur du bloc photoluminescent pour augmenter la proportion du premier rayonnement converti en deuxième rayonnement. En effet, ceci augmente la durée de parcours moyen du deuxième rayonnement dans le bloc photoluminescent et entraîne une augmentation de la réabsorption du deuxième rayonnement dans le bloc photoluminescent. L'efficacité lumineuse du dispositif optoélectronique peut donc être faible.

Un inconvénient des dispositifs optoélectroniques décrits précédemment est que le coût de fabrication des matériaux composant les blocs photoluminescents peut être élevé.

Le document US 2011/297975 décrit un dispositif optoélectronique comprenant des diodes électroluminescentes et des blocs photoluminescents.

### Résumé

Ainsi, un objet d'un mode de réalisation est de pallier au moins en partie les inconvénients des dispositifs optoélectroniques décrits précédemment comprenant des sources électroluminescentes et des blocs photoluminescents.

Un autre objet d'un mode de réalisation est que l'efficacité lumineuse du dispositif optoélectronique est augmentée.

Un autre objet d'un mode de réalisation est que la proportion du premier rayonnement converti par le bloc photoluminescent est augmentée.

Un autre objet d'un mode de réalisation est que la réabsorption du deuxième rayonnement dans le bloc photoluminescent est réduite.

Un objet de l'invention est de réduire les dimensions des blocs photoluminescents.

Un objet de l'invention à est que les dispositifs optoélectroniques comprenant des diodes électroluminescentes peuvent être fabriqués à une échelle industrielle et à bas coût.

Ainsi, un mode de réalisation prévoit un dispositif optoélectronique selon la revendication 1, comprenant :
des sources électroluminescentes, chaque source électroluminescente étant adaptée à émettre un premier rayonnement à une première longueur d'onde ;
des blocs photoluminescents répartis en premiers blocs photoluminescents adaptés à convertir par pompage optique le premier rayonnement en un deuxième rayonnement à une deuxième longueur d'onde et des deuxièmes blocs photoluminescents adaptés à convertir par pompage optique le premier rayonnement en un troisième rayonnement à une troisième longueur d'onde ; et
pour chaque bloc photoluminescent, un coupleur optique comprenant un premier cristal photonique entourant au moins partiellement ledit bloc photoluminescent et recouvrant, avec ledit bloc photoluminescent, l'une des sources électroluminescentes à côté dudit bloc photoluminescent, le coupleur optique étant adapté à modifier la direction de propagation de rayons du premier rayonnement émis par ladite source électroluminescente pour rediriger ces rayons vers ledit bloc photoluminescent.

Selon un mode de réalisation, chaque coupleur optique comprend une première couche d'un premier matériau ayant un premier indice de réfraction à la première longueur d'onde, la première couche ayant des première et deuxième faces opposées, la première ou deuxième face recouvrant ladite source électroluminescente, chaque coupleur optique comprenant en outre des premières ouvertures s'étendant dans la première couche depuis la première face et/ou la deuxième face et remplies d'un deuxième matériau ayant un deuxième indice de réfraction à la première longueur d'onde différent du premier indice de réfraction.

Selon un mode de réalisation, chaque bloc photoluminescent comprend un deuxième cristal photonique adapté à laisser passer le premier rayonnement, la vitesse de propagation du premier rayonnement dans le bloc photoluminescent étant inférieure à la vitesse de propagation du premier rayonnement dans le coupleur optique adjacent audit bloc photoluminescent.

Selon un mode de réalisation, chaque bloc photoluminescent comprend des particules monocristallines photoluminescentes de taille nanométrique d'un matériau semiconducteur.

Selon un mode de réalisation, chaque bloc photoluminescent comprend une deuxième couche d'un troisième matériau ayant un troisième indice de réfraction à la première longueur d'onde, la deuxième couche ayant des troisième et quatrième faces opposées, la troisième ou quatrième face recouvrant ladite source électroluminescente, chaque bloc photoluminescent comprenant en outre des deuxièmes ouvertures s'étendant dans la deuxième couche depuis la troisième et/ou quatrième face et remplies d'un quatrième matériau ayant un quatrième indice de réfraction à la première longueur d'onde différent du troisième indice de réfraction.

Selon un mode de réalisation, les particules monocristallines photoluminescentes sont situées dans la deuxième couche et/ou dans les deuxièmes ouvertures.

Selon un mode de réalisation, le dispositif comprend, en outre, pour chaque bloc photoluminescent, un premier miroir sélectif interposé entre ladite source lumineuse et ledit bloc photoluminescent, le premier miroir sélectif étant adapté à laisser passer le premier rayonnement et réfléchir le deuxième rayonnement et/ou le troisième rayonnement.

Selon un mode de réalisation, le premier miroir sélectif comprend un troisième cristal photonique.

Selon un mode de réalisation, le dispositif comprend, en outre, pour chaque bloc photoluminescent, un deuxième miroir sélectif, ledit bloc photoluminescent étant interposé entre ladite source lumineuse et ledit deuxième miroir, le deuxième miroir étant adapté à réfléchir le premier rayonnement et à laisser passer le deuxième rayonnement et/ou le troisième rayonnement.

Selon un mode de réalisation, le dispositif comprend en outre des troisièmes blocs photoluminescents adaptés à convertir par pompage optique le premier rayonnement en un quatrième rayonnement à une quatrième longueur d'onde.

Selon un mode de réalisation, le dispositif comprend en outre des murs réfléchissant les premier, deuxième et troisième rayonnements, lesdits murs séparant les sources électroluminescentes et séparant les blocs photoluminescents.

Selon un mode de réalisation, le dispositif comprend en outre un filtre recouvrant les blocs photoluminescents du côté des blocs photoluminescents opposé aux sources électroluminescentes et adapté à bloquer le premier rayonnement et à laisser passer les deuxième et troisième rayonnements.

Selon un mode de réalisation, les sources électroluminescentes comprennent des diodes électroluminescentes ou des diodes laser à cavité verticale émettant par la surface.

Un mode de réalisation prévoit également un procédé de fabrication, selon la revendication 14, d'un dispositif optoélectronique tel que défini précédemment, comprenant les étapes suivantes :
a) former les sources électroluminescentes ;
b) former les blocs photoluminescents sur les sources électroluminescentes ; et
d) former les coupleurs optiques sur les sources électroluminescentes, chaque coupleur optique entourant au moins partiellement l'un des blocs photoluminescents.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 et 2 sont respectivement une vue en coupe et une vue de dessus, partielles et schématiques, d'un mode de réalisation d'un dispositif optoélectronique ;
les figures 3 et 4 sont respectivement une vue en coupe et une vue de dessus, partielles et schématiques, d'un mode de réalisation d'un coupleur optique du dispositif optoélectronique représenté en figure 1 ;
les figures 5 et 6 sont respectivement une vue en coupe et une vue de dessus, partielles et schématiques, d'un mode de réalisation d'un bloc photoluminescent du dispositif optoélectronique représenté en figure 1 ;
la figure 7 représente une courbe d'évolution de la réflectivité en fonction de la longueur d'onde d'un mode de réalisation d'un bloc photoluminescent ;
les figures 8 à 11 sont des vues en coupe, partielles et schématiques, d'autres modes de réalisation du bloc photoluminescent du dispositif optoélectronique représenté en figure 1 ;
la figure 12 est une vue en coupe, partielle et schématique, d'un autre mode de réalisation d'un dispositif optoélectronique ;
la figure 13 est une vue en coupe, partielle et schématique, d'un mode de réalisation d'un miroir réfléchissant du dispositif optoélectronique représenté en figure 12 ;
la figure 14 représente une courbe d'évolution de la réflectivité en fonction de la longueur d'onde d'un mode de réalisation du miroir de la figure 13 ;
la figure 15 est une vue en coupe, partielle et schématique, d'un autre mode de réalisation d'un miroir réfléchissant du dispositif optoélectronique représenté en figure 12 ; et
la figure 16 est une vue en coupe, partielle et schématique, d'un autre mode de réalisation d'un dispositif optoélectronique.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande d'une source électroluminescente d'un dispositif optoélectronique, notamment d'une diode électroluminescente, sont bien connus de l'homme de l'art et ne sont pas décrits.

Dans la suite de la description, sauf indication contraire, les termes "sensiblement", "environ", "approximativement" et "de l'ordre de" signifient "à 10 % près". Lorsque les termes "sensiblement", "environ", "approximativement" et "de l'ordre de" sont utilisés en relation avec des angles ou des orientations, ils signifient "à 10° près". En outre, on appelle "zone active" d'une diode électroluminescente la région de la diode électroluminescente depuis laquelle est émise la majorité du rayonnement électromagnétique fourni par la diode électroluminescente.

Dans la suite de la description, un rayonnement est dit "à une longueur d'onde" donnée lorsque la majorité de l'énergie du rayonnement est à ladite longueur d'onde à 10 % prés.

En outre, le terme "particule" tel qu'utilisé dans le cadre de la présente demande doit être compris dans un sens large et correspond non seulement à des particules compactes ayant plus ou moins une forme sphérique mais aussi à des particules anguleuses, des particules aplaties, des particules en forme de flocons, des particules en forme de fibres, ou des particules fibreuses, etc. On comprendra que la "taille" des particules dans le cadre de la présente demande signifie la plus petite dimension transversale des particules. On entend par particules d'un matériau les particules prises individuellement, c'est-à-dire les éléments unitaires du matériau, sachant que le matériau peut se présenter sous la forme d'agglomérats de particules. Par l'expression "taille moyenne" de particules, on entend selon la présente demande la moyenne arithmétique des tailles des particules, c'est-à-dire la somme des tailles des particules divisée par le nombre de particules. La granulométrie des particules peut être mesurée par granulométrie laser en utilisant, par exemple, un Malvern Mastersizer 2000.

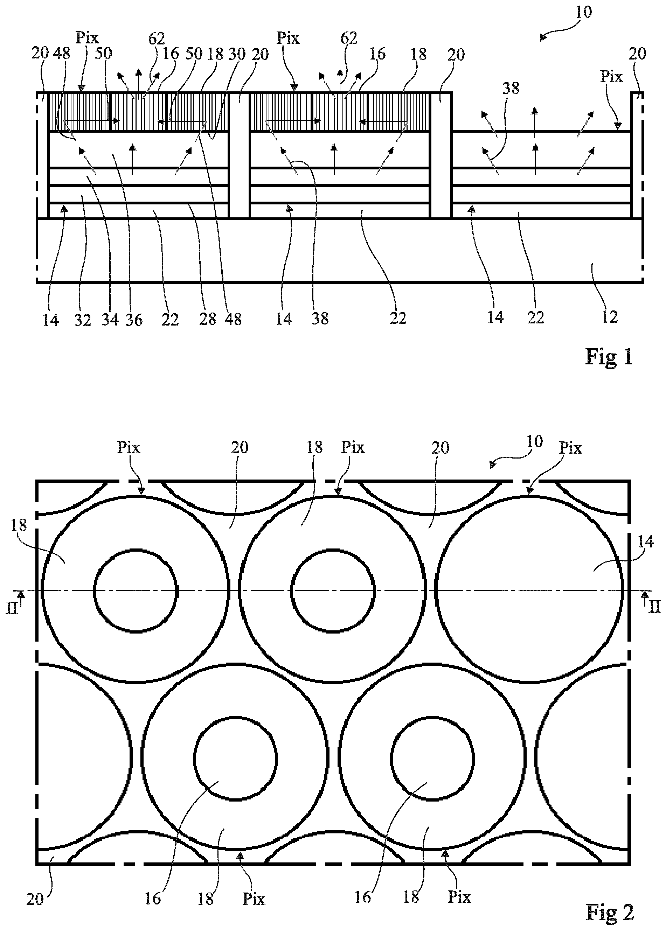

Les figures 1 et 2 représentent un mode de réalisation d'un dispositif optoélectronique 10, par exemple correspondant à un écran d'affichage ou à un dispositif de projection d'images comprenant des sous-pixels d'affichage Pix. La figure 1 est une coupe de la figure 2 selon la ligne II-II.

Le dispositif 10 comprend un support 12 et, pour chaque sous-pixel d'affichage Pix, une source électroluminescente 14 adaptée à émettre un premier rayonnement à une première longueur d'onde et reposant sur le support 12. Le dispositif 10 comprend en outre, pour au moins certains des sous-pixels d'affichage Pix, un bloc photoluminescent 16 reposant sur la source électroluminescente 14 et un coupleur optique 18 reposant sur la source électroluminescente 14 et entourant le bloc photoluminescent 16. Chaque bloc photoluminescent 16 est adapté à convertir le premier rayonnement émis par la source électroluminescente 14 en un rayonnement à une autre longueur d'onde. Chaque coupleur optique 18 est adapté à diriger le premier rayonnement vers le bloc photoluminescent 16 qu'il entoure.

Selon un mode de réalisation, toutes les sources électroluminescentes 14 émettent un rayonnement à une première longueur d'onde.

Selon un mode de réalisation, le dispositif optoélectronique 10 comprend au moins deux types de blocs photoluminescents 16. Les blocs photoluminescents 16 du premier type sont adaptés à convertir le premier rayonnement à la première longueur d'onde en un deuxième rayonnement à une deuxième longueur d'onde par pompage optique. Les blocs photoluminescents 16 du deuxième type sont adaptés à convertir le premier rayonnement à la première longueur d'onde en un troisième rayonnement à une troisième longueur d'onde par pompage optique. Selon un mode de réalisation, le dispositif optoélectronique 10 comprend au moins trois types de blocs photoluminescents 16, les blocs photoluminescents 16 du troisième type étant adaptés à convertir le premier rayonnement à la première longueur d'onde en un quatrième rayonnement à une quatrième longueur d'onde par pompage optique.

Selon un mode de réalisation, la première longueur d'onde correspond à un rayonnement ultraviolet, et est dans la plage de 350 nm à 430 nm. Selon un mode de réalisation, la deuxième longueur d'onde correspond à de la lumière verte et est dans la plage de 510 nm à 570 nm. Selon un mode de réalisation, la troisième longueur d'onde correspond à de la lumière rouge et est dans la plage de 600 nm à 720 nm. Selon un mode de réalisation, la quatrième longueur d'onde correspond à de la lumière bleue et est dans la plage de 440 nm à 490 nm. Pour chaque pixel de l'image à afficher, le dispositif optoélectronique 10 comprend alors au moins un sous-pixel d'affichage Pix avec un bloc photoluminescent 16 du premier type, un sous-pixel d'affichage Pix avec un bloc photoluminescent 16 du deuxième type et un sous-pixel d'affichage Pix du troisième type.

Selon un mode de réalisation, le dispositif optoélectronique 10 comprend des blocs photoluminescents 16 d'un quatrième type. Les blocs photoluminescents 16 du quatrième type sont adaptés à convertir le premier rayonnement à la première longueur d'onde en un cinquième rayonnement à une cinquième longueur d'onde par pompage optique. Selon un mode de réalisation, la cinquième longueur d'onde correspond à de la lumière jaune et est dans la plage de 570 nm à 600 nm. Selon un mode de réalisation, les première, deuxième, troisième, quatrième et cinquième longueurs d'ondes sont différentes. Pour chaque pixel de l'image à afficher, le dispositif optoélectronique 10 comprend des sous-pixels avec des blocs photoluminescents 16 des quatre types.

Selon un mode de réalisation, la première longueur d'onde correspond à de la lumière bleue et est dans la plage de 440 nm à 490 nm. Dans ce mode de réalisation, comme cela est représenté sur les figures 1 et 2, pour chaque pixel de l'image à afficher, le circuit optoélectronique 12 comprend un sous-pixel d'affichage Pix avec un bloc photoluminescent 16 du premier type, un sous-pixel d'affichage Pix avec un bloc photoluminescent 16 du deuxième type et un sous-pixel d'affichage sans bloc photoluminescent.

Le dispositif 10 peut, en outre, comprendre des murs réfléchissants 20 qui s'étendent entre les sources électroluminescentes 14 et les blocs photoluminescents 16 et qui forment une grille délimitant les sous-pixels d'affichage Pix. Les murs 20 réduisent la diaphonie entre sous-pixels Pix adjacents. Le dispositif 10 peut, en outre, comprendre, pour chaque sous-pixel d'affichage Pix, un miroir 22 adapté à réfléchir le premier rayonnement et disposé entre le support 12 et la source électroluminescente 14.

Le dispositif 10 peut, en outre, comprendre un filtre, non représenté, recouvrant les blocs photoluminescents et adapté à bloquer le premier rayonnement et à laisser passer les deuxième et troisième rayonnements. Le filtre peut avoir une structure multicouche. Selon un mode de réalisation, pour des sources électroluminescentes 14 émettant un rayonnement à la première longueur d'onde dans la plage de 350 nm à 430 nm, le filtre peut être un filtre passe-bande ne laissant passer que les longueurs d'onde dans la plage de 440 nm à 720 nm.

Le dispositif 10 comprend, en outre, des éléments de connexion, non représentés, permettant de commander les sources électroluminescentes 14.

Le support 12 peut comprendre des composants électroniques, non représentés, notamment des transistors, utilisés pour la commande des sources électroluminescentes 14. A titre de variante, le support 12 peut ne pas être présent et le dispositif optoélectronique 10 peut être connecté à un circuit électronique de commande des sources électroluminescentes 14.

Selon un mode de réalisation, les sources électroluminescentes 14 correspondent à des diodes électroluminescentes.

Selon un mode de réalisation, chaque diode électroluminescente 14 peut correspondre à une diode électroluminescente dite bidimensionnelle comprenant un empilement de couches semiconductrices sensiblement planes dont la zone active.

A titre d'exemple, en figure 1, chaque diode électroluminescente 14 comprend un empilement de couches semiconductrices ayant deux faces opposées 28, 30. L'empilement comprend, du bas vers le haut en figure 1 :
une couche semiconductrice 32 dopée d'un premier type de conductivité, par exemple dopée de type P et délimitant la face 28 ;
une zone active 34 ; et
une couche semiconductrice 36 dopée d'un deuxième type de conductivité, par exemple dopée de type N et délimitant la face 30.

Dans ce mode de réalisation, en fonctionnement, pour au moins certains des sous-pixels Pix, des tensions sont appliquées entre les couches semiconductrices 32 et 36 de sorte que la zone active 34 de la source électroluminescente 14 du sous-pixel Pix émet le premier rayonnement (flèches 38 en figure 1) avec une intensité qui dépend de la tension appliquée entre les couches semiconductrices 32 et 36.

Selon un mode de réalisation, chaque diode électroluminescente 14 peut comprendre au moins une diode électroluminescente dite tridimensionnelle comprenant une coque semiconductrice recouvrant un élément semiconducteur tridimensionnel, notamment un microfil, un nanofil, un cône, un tronc de cône, une pyramide ou une pyramide tronquée, la coque étant formée d'un empilement de couches semiconductrices non planes dont la zone active.

Selon un autre mode de réalisation, les sources électroluminescentes 14 correspondent à des diodes laser à cavité verticale émettant par la surface ou VCSEL.

Selon un mode de réalisation, les sources électroluminescentes 14 sont disposées selon un damier hexagonal. Dans le présent mode de réalisation, les sources électroluminescentes 14 et les blocs photoluminescents 16 ont, dans la vue de dessus de la figure 2, une forme circulaire. Toutefois, la forme des sources électroluminescentes 14 et des blocs photoluminescents 16 peut être différente, par exemple, carrée, rectangulaire ou hexagonale.

Selon l'invention, chaque coupleur optique 18 correspond à un cristal photonique adapté à diriger les rayons lumineux du premier rayonnement qu'il reçoit vers le bloc photoluminescent 16 qu'il entoure.

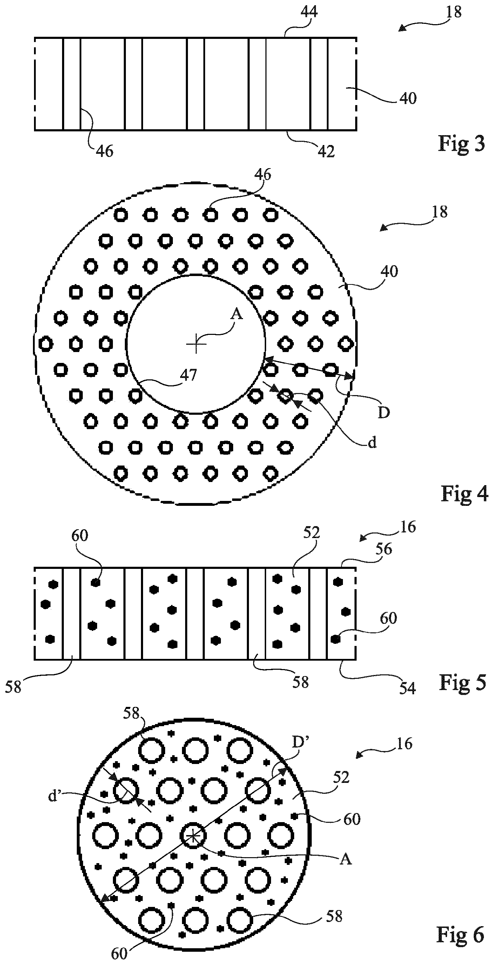

Les figures 3 et 4 sont respectivement une vue en coupe partielle et une vue de dessus d'un mode de réalisation du coupleur optique 18.

Dans le présent mode de réalisation, le coupleur optique 18 comprend une couche 40 d'un premier matériau ayant un premier indice de réfraction à la première longueur d'onde. La couche 40 a deux faces 42, 44 planes et parallèles, la face 42 étant située du côté de la source électroluminescente 14 et étant, par exemple, au contact de la face 30. Des ouvertures 46 s'étendent dans la couche 40 de la face 44 à la face 42. Dans le présent mode de réalisation, les ouvertures 46 s'étendent sur la totalité de l'épaisseur de la couche 40. A titre de variante, les ouvertures 46 peuvent s'étendre seulement sur une partie de l'épaisseur de la couche 40 depuis la face 44 ou depuis la face 42. Chaque ouverture 46 s'étend par exemple selon un axe qui est sensiblement orthogonal aux faces 42 et 44. Chaque ouverture 46 est remplie d'un deuxième matériau, qui peut être de l'air, ayant un deuxième indice de réfraction à la première longueur d'onde strictement inférieur au premier indice de réfraction. De préférence, l'écart entre le premier indice de réfraction et le deuxième indice de réfraction est le plus grand possible. Le coupleur optique 18 est traversé par un trou 47 d'axe A dans lequel est disposé le bloc photoluminescent 16 du sous-pixel. On appelle D la dimension du coupleur optique 18 mesurée radialement et d la dimension d'une ouverture 46 mesurée radialement.

Les ouvertures 46 sont disposées dans la couche 40 selon un réseau périodique ou pseudo-périodique. Les sections droites, dans un plan parallèle aux faces 42, 44, des ouvertures 46 peuvent être identiques ou dépendre de l'ouverture 46 considérée. Comme cela est illustré en figure 1, la forme et la disposition des ouvertures 46 sont choisies pour que les rayons 48 du premier rayonnement qui pénètrent dans le coupleur optique 18 soient redirigés vers le bloc photoluminescent 16 entouré par le coupleur optique 18. De préférence, les rayons 50 du premier rayonnement qui sortent du coupleur optique 18 sont sensiblement parallèles aux faces 42, 44 du coupleur optique 18 et dirigés vers l'axe A.

Selon un mode de réalisation, les ouvertures 46 peuvent être sensiblement alignées selon des directions radiales par rapport à l'axe A.

En figure 4, les ouvertures 46 ont en vue de dessus une section droite de forme circulaire. Toutefois, la section droite des ouvertures 46 peut être différente, par exemple, carrée, rectangulaire ou hexagonale. A titre de variante, les ouvertures 46 peuvent correspondre à des anneaux entourant le trou central 47, par exemple des anneaux concentriques d'axe A.

Le premier matériau peut être transparent dans la gamme visible. Le premier matériau peut être un oxyde, un nitrure ou un matériau organique. Selon un mode de réalisation, le premier matériau est choisi parmi le groupe comprenant l'oxyde de titane (TiO₂), l'oxyde d'aluminium (Al₂O₃), le nitrure de silicium (SiN), l'oxynitrure de silicium (SiO_{y}Nₓ), l'oxyde de silicium (SiO₂), l'oxyde de zirconium (ZrO₂), l'oxyde d'hafnium (HfO₂), l'oxyde de lutécium (Lu₂O₃), l'oxyde de magnésium (MgO), l'oxyde d'yttrium (Y₂O₃), l'oxyde de zinc (ZnO), le poly(méthacrylate de méthyle) (PMMA), les silicones, les résines photosensibles et les alliages ou mélanges d'au moins deux de ces composés. La couche 40 est au moins en partie transparente au premier rayonnement. L'indice de réfraction du premier matériau à la première longueur d'onde est compris entre 1,4 et 4.

Le deuxième matériau est choisi parmi le groupe comprenant l'air, les oxydes d'indice de réfraction à la première longueur d'onde inférieur à 1,5 transparents dans la gamme visible, notamment l'oxyde de silicium (SiO₂), ou les matériaux organiques transparents dans la gamme visible, tels que le PMMA ou les silicones. L'indice de réfraction du deuxième matériau à la première longueur d'onde est compris entre 1 et 1,5.

La hauteur de la couche 40, mesurée selon une direction perpendiculaire à la face 28, est comprise entre 100 nm et 500 nm, et préférentiellement entre 150 nm et 350 nm. En vue de dessus, le coupleur est inscrit dans un cercle dont le diamètre est compris entre 3 µm et 50 µm. Le pas entre les centres de deux ouvertures 46 adjacentes est compris entre 150 nm et 250 nm. Le rapport entre la dimension d et le pas entre les centres de deux ouvertures 46 adjacentes, également appelé facteur de remplissage des ouvertures 46, est compris entre 10 % et 90 %.

Selon un mode de réalisation, lorsque la première longueur d'onde est égale à 450 nm, le coupleur optique 18 peut comprendre une couche 40 en TiO₂ dont l'indice de réfraction à la longueur d'onde de 450 nm est égal à 3,14 et les ouvertures 46 peuvent être remplies d'air dont l'indice de réfraction à la longueur d'onde de 450 nm est égal à 1. Le pas entre deux ouvertures adjacentes 46 peut être de l'ordre de 203 nm et la dimension d est de l'ordre de 101 nm. Pour une succession de vingt ouvertures 46 sensiblement alignées radialement, la dimension D du coupleur optique 18 est de l'ordre de 4 µm.

Selon un mode de réalisation, chaque bloc photoluminescent 16 comprend des luminophores dispersés dans une matrice. Les luminophores peuvent être des particules monocristallines de taille nanométrique d'un matériau semiconducteur, également appelées nanocristaux semiconducteurs par la suite. Les luminophores peuvent être des luminophores organiques. Selon un autre mode de réalisation, chaque bloc photoluminescent 16 comprend un empilement de couches semiconductrices formant des puits quantiques multiples.

Selon un mode de réalisation, chaque bloc photoluminescent 16 correspond, en outre, à un cristal photonique adapté à ralentir les rayons lumineux du premier rayonnement qu'il reçoit depuis le coupleur optique 18 qui l'entoure sans toutefois ralentir le rayonnement fourni par le bloc photoluminescent 16 après conversion par pompage optique.

Les figures 5 et 6 sont respectivement une vue en coupe partielle et une vue de dessus d'un mode de réalisation du bloc photoluminescent 16.

Selon le présent mode de réalisation, chaque bloc photoluminescent 16 comprend une couche 52 d'un troisième matériau ayant un troisième indice de réfraction à la première longueur d'onde. La couche 52 a deux faces 54, 56 planes et parallèles, la face 54 étant située du côté de la source électroluminescente 14 et étant, par exemple, au contact de la face 30. Des ouvertures 58 s'étendent dans la couche 52 depuis la face 56. Dans le présent mode de réalisation, les ouvertures 58 s'étendent sur la totalité de l'épaisseur de la couche 52. Chaque ouverture 58 s'étend par exemple selon un axe qui est sensiblement orthogonal aux faces 54 et 56. Chaque ouverture 58 est remplie d'un quatrième matériau ayant un quatrième indice de réfraction à la première longueur d'onde strictement inférieur au troisième indice de réfraction. Le quatrième matériau peut être identique au deuxième matériau. On appelle D' la dimension du bloc photoluminescent 16 mesurée radialement et d' la dimension de l'ouverture 58 mesurée radialement.

Le bloc photoluminescent 16 comprend en outre des luminophores 60 adaptés à convertir le premier rayonnement en un autre rayonnement. Dans le présent mode de réalisation, les luminophores 60 sont situés dans la couche 52.

Les ouvertures 58 sont disposées dans la couche 52 selon un réseau périodique ou pseudo-périodique. Les sections droites, dans un plan parallèle aux faces 54, 56, des ouvertures 58 peuvent être identiques ou dépendre de l'ouverture 58 considérée. La forme et la disposition des ouvertures 58 sont choisies pour que les rayons 50 du premier rayonnement qui pénètrent dans le bloc photoluminescent 16 continuent leur progression dans le bloc photoluminescent 16 sans changer globalement de direction de propagation mais avec une vitesse de propagation moyenne réduite par rapport à la vitesse de propagation moyenne des rayons du premier rayonnement dans la source lumineuse 14 ou dans le coupleur optique 18. Selon un mode de réalisation, les ouvertures 58 peuvent être sensiblement alignées selon des directions radiales par rapport à l'axe A.

Selon un mode de réalisation, chaque bloc photoluminescent 16 a la structure d'un miroir à cristal photonique, notamment un miroir de Bragg. Les caractéristiques du miroir à cristal photonique sont définies de façon que la borne inférieure de la bande interdite du miroir à cristal photonique soit sensiblement égale à la première longueur d'onde ou que la borne supérieure de la bande interdite du miroir à cristal photonique soit sensiblement égale à la première longueur d'onde. De ce fait, le premier rayonnement se propage dans le bloc photoluminescent 16 sensiblement sans réflexion mais avec une vitesse de propagation moyenne réduite. La durée du parcours du premier rayonnement dans le bloc photoluminescent 16 étant augmentée, l'absorption du premier rayonnement par les luminophores 60 pour une conversion en un rayonnement à une autre longueur d'onde est augmentée d'au moins un facteur 1,5 par rapport à un bloc photoluminescent dans lequel les ouvertures 58 ne seraient pas présentes. Le rayonnement émis par le bloc photoluminescent 16 après conversion du premier rayonnement par pompage optique est à une longueur d'onde nettement supérieure aux longueurs d'onde de la bande interdite du miroir à cristal photonique de sorte que ce rayonnement se propage sensiblement librement dans le bloc photoluminescent 16. Etant donné que ce rayonnement est émis dans toutes les directions, il s'échappe du bloc photoluminescent 16 comme cela est représenté par les flèches 62 en figure 1. De préférence, la vitesse de propagation moyenne du rayonnement émis par le bloc photoluminescent 16 par pompage optique est supérieure à la vitesse de propagation moyenne du premier rayonnement dans le bloc photoluminescent 16.

En figure 6, les ouvertures 58 ont en vue de dessus une section droite de forme circulaire. Toutefois, la section droite des ouvertures 58 peut être différente, par exemple, carrée, rectangulaire ou hexagonale. A titre de variante, les ouvertures 58 peuvent correspondre à des anneaux, par exemple des anneaux concentriques d'axe A.

Le troisième matériau est choisi parmi le groupe comprenant un polymère, notamment le PMMA, les silicones et les résines photosensibles. La couche 52 est au moins en partie transparente au premier rayonnement. L'indice de réfraction du troisième matériau à la première longueur d'onde est compris entre 1,4 et 4.

Le quatrième matériau est par exemple l'air.

La hauteur de la couche 52, mesurée selon une direction perpendiculaire à la face 28, est comprise entre 100 nm et 500 nm. Selon un mode de réalisation, la hauteur de la couche 52 est sensiblement égale à la hauteur de la couche 40. En vue de dessus, le bloc photoluminescent 16 est inscrit dans un cercle dont le diamètre D' est compris entre 3 µm et 40 µm. Selon un mode de réalisation, le rapport entre le pas, en vue de dessus, entre les centres de deux ouvertures 58 adjacentes et la première longueur d'onde est approximativement égale à 0,355. Le pas entre deux ouvertures 58 adjacentes est compris entre 124 nm (pour une première longueur d'onde de 350 nm) et 163 nm (pour une première longueur d'onde de 460 nm). La dimension d' de chaque ouverture 58 est choisie pour que le rapport entre la dimension d' et le pas entre les centres de deux ouvertures 58 adjacentes, également appelé facteur de remplissage des ouvertures 58, soit compris entre 10 % et 90 %.

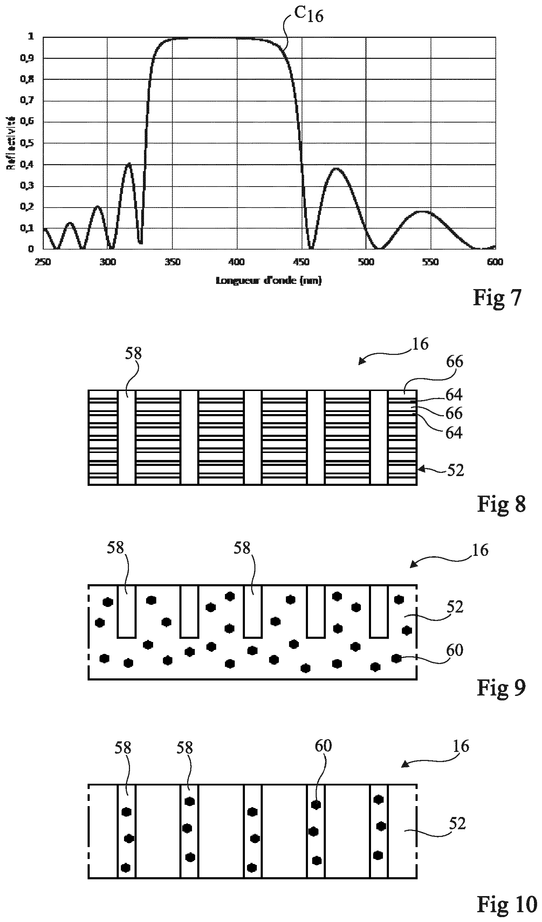

La figure 7 représente une courbe d'évolution C₁₆ de la réflectivité en fonction de la longueur d'onde d'un mode de réalisation du bloc photoluminescent 16 pour lequel les ouvertures 58 ont une dimension de l'ordre de 60 nm et sont remplies d'air et pour lequel la couche 52 est en silicone avec des luminophores 60 du type boîtes quantiques ayant une dimension de l'ordre de 60 nm. L'indice de réfraction à la longueur d'onde de 450 nm de l'ensemble formé par la couche 52 et les luminophores 60 est égal à environ 1,56. Le pas entre deux ouvertures adjacentes 58 est de l'ordre de 160 nm et la dimension est de l'ordre de 100 nm. Ceci conduit à l'obtention d'un miroir à cristal photonique dont la borne inférieure de la bande interdite est approximativement égale à 450 nm.

La figure 8 est une vue en coupe agrandie d'un autre mode de réalisation du bloc photoluminescent 16 dans lequel le bloc photoluminescent 16 comprend des puits quantiques multiples. La couche 52 correspond alors à un empilement de couches semiconductrices formant une alternance de puits quantiques 64 et de couches barrières 66 et les ouvertures 58 traversent les couches semiconductrices de l'empilement sensiblement selon la direction d'empilement. La couche de l'empilement de couches la plus proche de la couche semiconductrice 36 peut jouer le rôle de couche d'arrêt de gravure lors de la formation des ouvertures 58. Les couches barrières 66 et les puits quantiques 64 sont en des matériaux différents pouvant correspondre à des alliages du type AlInGaN dans lesquels les proportions d'indium et d'aluminium, éventuellement nulles, sont différentes. Comme la couche 52 est composée d'au moins deux matériaux différents, les propriétés optiques du troisième matériau décrit précédemment, qui sont utilisées pour la détermination des propriétés optiques du bloc photoluminescent 16, sont alors définies à partir des propriétés optiques du matériau composant les couches barrières 66 et du matériau composant les couches de puits quantiques 64. A titre d'exemple, on peut considérer que l'indice de réfraction optique du troisième matériau est égal à la moyenne des indices de réfraction optique des matériaux composant les couches de puits quantiques 64 et les couches barrières 66 pondérée par les épaisseurs de ces couches. Le quatrième matériau peut être un oxyde (SiO₂), un carbure de silicium dont l'indice de réfraction est inférieur à celui du troisième matériau, de l'air ou un polymère.

La figure 9 est une vue en coupe agrandie d'un autre mode de réalisation du bloc photoluminescent 16 dans lequel les ouvertures 58 s'étendent seulement sur une partie de l'épaisseur de la couche 52. Dans le cas où le bloc photoluminescent 16 comprend des puits quantiques multiples, la gravure des ouvertures 58 peut s'arrêter de manière sélective sur une couche d'arrêt prévue dans l'empilement de couches, ce qui permet d'obtenir des ouvertures 58 à la profondeur souhaitée.

La figure 10 est une vue en coupe agrandie d'un autre mode de réalisation du bloc photoluminescent 16 dans lequel les luminophores 60 sont situés seulement dans les ouvertures 58.

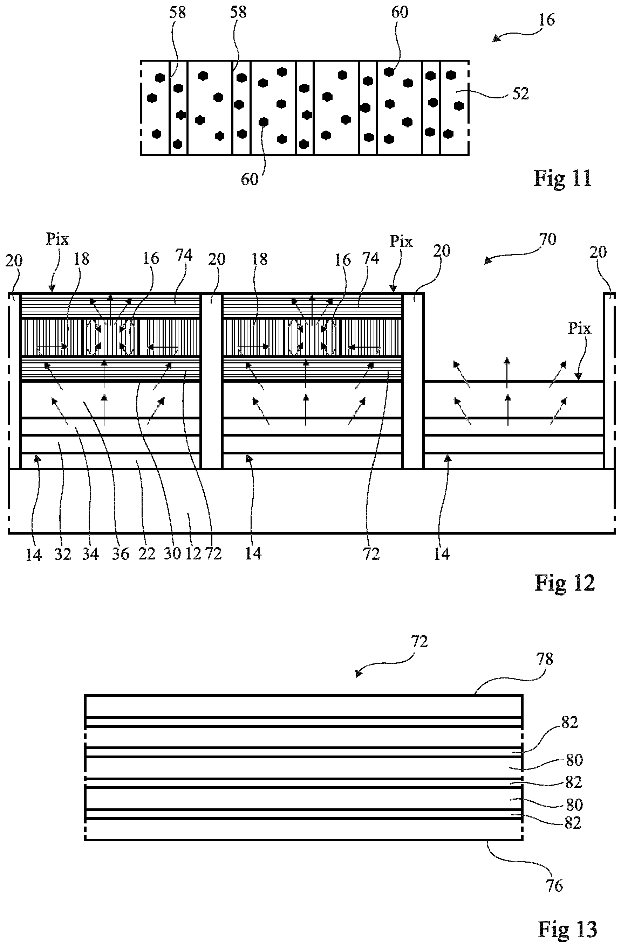

La figure 11 est une vue en coupe agrandie d'un autre mode de réalisation du bloc photoluminescent 16 dans lequel les luminophores 60 sont situés à la fois dans la couche 52 et dans les ouvertures 58.

Selon un mode de réalisation, les couches semiconductrices formant la source lumineuse 14 sont au moins en partie en un matériau semiconducteur. Le matériau semiconducteur peut être le silicium, le germanium, le carbure de silicium, un composé III-V, un composé II-VI, ou une combinaison d'au moins deux de ces composés.

Les couches semiconductrices formant la source lumineuse 14 peuvent être, au moins en partie, en des matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les couches semiconductrices formant la source lumineuse 14 peuvent être, au moins en partie, en des matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires.

La zone active 34 est la couche depuis laquelle est émise la majorité du rayonnement fourni par la source électroluminescente 14. La zone active 34 peut comporter des moyens de confinement. La zone active 34 peut comprendre un puits quantique unique. Elle peut alors comprendre un matériau semiconducteur différent du matériau semiconducteur formant les couches semiconductrices 32 et 36 et ayant une bande interdite inférieure à celle des couches semiconductrices 32 et 36. La zone active 34 peut comprendre des puits quantiques multiples. Elle comprend alors un empilement de couches semiconductrices formant une alternance de puits quantiques et de couches barrières. Elle est par exemple formée d'une alternance de couches de GaN et de InGaN ayant des épaisseurs respectives de 3 nm à 20 nm (par exemple 6 nm) et de 1 nm à 30 nm (par exemple 2,5 nm). Les couches de GaN peuvent être dopées, par exemple, de type N ou P. Selon un autre exemple, la zone active 34 peut comprendre une seule couche de InGaN, ayant par exemple une épaisseur supérieure à 10 nm.

La hauteur des murs 20, mesurée selon une direction perpendiculaire à la face 28, est comprise entre 500 nm et 100 µm, de préférence entre 5 µm et 30 µm. L'épaisseur minimale des murs 20, mesurée selon une direction parallèle à la face 28, est comprise entre 20 nm et 50 µm, de préférence entre 50 nm et 10 µm. Dans la vue de la figure 2, l'aire de chaque source électroluminescente 14 correspond à l'aire d'un cercle ayant un rayon compris entre 1 µm et 100 µm, de préférence entre 3 µm et 15 µm.

Selon un mode de réalisation, les murs 20 sont isolés électriquement des couches actives 34. Selon un mode de réalisation, les murs 20 peuvent être formés d'un matériau réfléchissant ou recouverts d'un revêtement réfléchissant le rayonnement émis par les blocs photoluminescents 16 et/ou les sources électroluminescentes 14. A titre d'exemple, les murs 20 peuvent comprendre un coeur métallique, notamment en aluminium (Al), en cuivre (Cu), ou en argent (Ag), recouvert d'une couche isolante électriquement, par exemple un oxyde.

Selon un mode de réalisation, les luminophores 60 sont des particules monocristallines de taille nanométrique d'un matériau semiconducteur, également appelées nanocristaux semiconducteurs par la suite. Le rendement quantique interne QYᵢₙₜ d'un matériau photoluminescent est égal au rapport entre le nombre de photons émis et le nombre de photons absorbés par la substance photoluminescente. Le rendement quantique interne QYᵢₙₜ des nanocristaux semiconducteurs est supérieur à 5 %, de préférence supérieur à 10 %, plus préférentiellement supérieur à 20 %.

Selon un mode de réalisation, la taille moyenne des nanocristaux est comprise entre 0,5 nm et 1000 nm, de préférence entre 0,5 nm et 500 nm, encore plus préférentiellement entre 1 nm et 100 nm, notamment entre 2 nm et 30 nm. Pour des dimensions inférieures à 50 nm, les propriétés de photoconversion des nanocristaux semiconducteurs dépendent essentiellement de phénomènes de confinement quantique. Les nanocristaux semiconducteurs correspondent alors à des boîtes quantiques.

Selon un mode de réalisation, le matériau semiconducteur des nanocristaux semiconducteurs est choisi parmi le groupe comprenant le séléniure de cadmium (CdSe), le phosphure d'indium (InP), le sulfure de cadmium (CdS), le sulfure de zinc (ZnS), le séléniure de zinc (ZnSe), le tellurure de cadmium (CdTe), le tellurure de zinc (ZnTe), l'oxyde de cadmium (CdO), l'oxyde de zinc et de cadmium (ZnCdO), le sulfure de zinc et de cadmium (CdZnS), le séléniure de zinc et de cadmium (CdZnSe), le sulfure d'argent et d'indium (AgInS₂), les alliages à base d'aluminium, d'indium et de gallium (AlInGa) et un mélange d'au moins deux de ces composés. Selon un mode de réalisation, le matériau semiconducteur des nanocristaux semiconducteurs est choisi parmi les matériaux cités dans la publication au nom de Le Blevenec et al. de Physica Status Solidi (RRL) - Rapid Research Letters Volume 8, No. 4, pages 349-352, avril 2014.

Selon un mode de réalisation, les dimensions des nanocristaux semiconducteurs sont choisies selon la longueur d'onde recherchée du rayonnement émis par les nanocristaux semiconducteurs. A titre d'exemple, des nanocristaux de CdSe dont la taille moyenne est de l'ordre de 3,6 nm sont adaptés à convertir de la lumière bleue en lumière rouge et des nanocristaux de CdSe dont la taille moyenne est de l'ordre de 1,3 nm sont adaptés à convertir de la lumière bleue en lumière verte. Selon un autre mode de réalisation, la composition des nanocristaux semiconducteurs est choisie selon la longueur d'onde recherchée du rayonnement émis par les nanocristaux semiconducteurs.

Selon un mode de réalisation, chaque bloc photoluminescent 16 contient de 2 % à 90 %, de préférence de 10 % à 60 %, en poids de nanocristaux, par exemple environ 20 % en poids de nanocristaux.

La figure 12 est une vue en coupe, partielle et schématique, d'un mode de réalisation d'un dispositif optoélectronique 70. Le dispositif optoélectronique 70 comprend les mêmes éléments que le dispositif optoélectronique 10 représenté en figure 1, et comprend en outre, pour chaque sous-pixel d'affichage Pix, un miroir sélectif 72 interposé entre la source électroluminescente 14 et le bloc photoluminescent 16 et un miroir sélectif 74 recouvrant le bloc photoluminescent 16 du côté du bloc photoluminescent 16 opposé à la source électroluminescente 14.

Le miroir sélectif 72 est adapté à laisser passer le premier rayonnement et à réfléchir le rayonnement émis par le bloc photoluminescent 16. Le miroir sélectif 72 permet, de façon avantageuse, d'éviter que le rayonnement fourni par le bloc photoluminescent 16 ne s'échappe du bloc photoluminescent 16 du côté de la source électroluminescente 14.

Le miroir sélectif 74 est adapté à laisser passer le rayonnement émis par le bloc photoluminescent 16 et à réfléchir le premier rayonnement. Le miroir sélectif 74 permet, de façon avantageuse, d'éviter que le premier rayonnement ne s'échappe du bloc photoluminescent 16 vers l'observateur. En outre, en réfléchissant le premier rayonnement dans le bloc photoluminescent 16, le miroir 74 permet d'augmenter la distance parcourue par le premier rayonnement dans le bloc photoluminescent 16 et donc d'augmenter la proportion du premier rayonnement qui est converti par le bloc photoluminescent 16.

Selon un mode de réalisation, chaque miroir 72, 74 correspond à un cristal photonique, par exemple à un miroir de Bragg.

La figure 13 représente un mode de réalisation du miroir sélectif 72 dans le cas où le miroir 72 a la structure d'un miroir de Bragg. Le miroir sélectif 72 comprend deux faces 76 et 78, la face 76 reposant sur la face 30 de la source électroluminescente 14, de préférence au contact de la source électroluminescente 14, le coupleur optique 18 et le bloc photoluminescent 16 reposant sur la face 78, de préférence au contact de la face 78. Le miroir 72 comprend une alternance de première et deuxième couches diélectriques 80, 82, sensiblement planes et parallèles à la face 76. Les premières couches diélectriques 80 sont en un cinquième matériau ayant un cinquième indice de réfraction à la longueur d'onde du rayonnement émis par le bloc photoluminescent 16 et les deuxièmes couches diélectriques 82 sont en un sixième matériau ayant un sixième indice de réfraction à la longueur d'onde du rayonnement émis par le bloc photoluminescent 16 strictement inférieur au cinquième indice de réfraction.

Le cinquième matériau peut être un oxyde, un nitrure ou un matériau organique. Selon un mode de réalisation, le cinquième matériau est choisi parmi le groupe comprenant l'oxyde de titane (TiO₂), l'oxyde d'aluminium (Al₂O₃), le nitrure de silicium (SiN), l'oxynitrure de silicium (SiO_{y}Nₓ), l'oxyde de silicium (SiO₂), l'oxyde de zirconium (ZrO₂), l'oxyde d'hafnium (HfO₂), l'oxyde de lutécium (Lu₂O₃), l'oxyde de magnésium (MgO), l'oxyde d'yttrium (Y₂O₃), l'oxyde de zinc (ZnO), le poly(méthacrylate de méthyle) (PMMA), les silicones, les résines photosensibles et les alliages ou mélanges d'au moins deux de ces composés. L'indice de réfraction du cinquième matériau à la longueur d'onde du rayonnement émis par le bloc photoluminescent 16 est compris entre 1,4 et 4.

Le sixième matériau est choisi parmi le groupe comprenant l'air, les oxydes d'indice de réfraction à la première longueur d'onde inférieur à 1,5 transparents dans la gamme visible, notamment l'oxyde de silicium (SiO₂), ou les matériaux organiques transparents dans la gamme visible, tels que le PMMA ou les silicones. L'indice de réfraction du sixième matériau à la longueur d'onde du rayonnement émis par le bloc photoluminescent 16 est compris entre 1 et 1,5.

La structure du miroir sélectif 72 peut être identique pour tous les sous-pixels d'affichage Pix.

Le miroir 74 peut avoir la même structure que le miroir 72, les épaisseurs des couches 80 et 82 du miroir 74 étant choisies pour laisser passer le rayonnement émis par le bloc photoluminescent 16 et réfléchir le premier rayonnement.

La structure du miroir sélectif 74 peut être identique pour tous les sous-pixels d'affichage Pix.

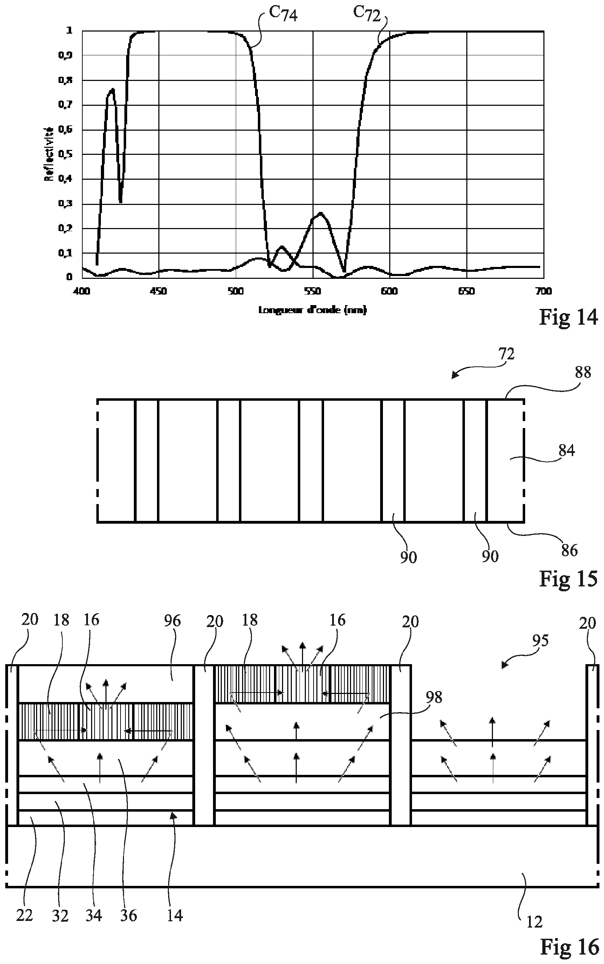

La figure 14 représente des courbes d'évolution C₇₂ et C₇₄ de la réflectivité en fonction de la longueur d'onde respectivement dans le cas où le miroir 72 comprend, pris en sandwich entre des couches d'oxyde de silicium de 57 nm, un empilement comprenant la répétition, au moins six fois, d'un motif comprenant une couche d'oxyde de titane de 74 nm et une couche d'oxyde de silicium de 115 nm et dans le cas où le miroir 74 comprend, pris en sandwich entre des couches d'oxyde de titane de 15 nm, un empilement comprenant la répétition, au moins douze fois, d'un motif comprenant une couche d'oxyde de titane de 31 nm et une couche d'oxyde de silicium de 64 nm.

Le miroir 72 est sensiblement transparent pour un premier rayonnement à la longueur d'onde de 450 nm et réfléchit le rayonnement émis par le bloc photoluminescent 16 pour des longueurs d'onde comprises entre 570 nm et 700 nm. Le miroir 74 est sensiblement transparent pour le rayonnement émis par le bloc photoluminescent 16 à des longueurs d'onde comprises entre 520 nm et 700 nm et réfléchit le premier rayonnement à la longueur d'onde de 450 nm.

La figure 15 est une vue en coupe agrandie d'un autre mode de réalisation du miroir 72, dans lequel le miroir a une structure analogue à celle représentée sur la figure 3.

Selon un mode de réalisation, le miroir 72 comprend une couche 84 ayant deux faces 86, 88 opposées et parallèles, du cinquième matériau. Des ouvertures 90 s'étendent dans la couche 84 depuis la face 88. Dans le présent mode de réalisation, les ouvertures 90 s'étendent sur la totalité de l'épaisseur de la couche 84. Chaque ouverture 90 est remplie du sixième matériau, qui par rapport à la liste précédente peut en outre correspondre à de l'air. Les dimensions et la répartition des ouvertures 90 sont choisies pour que le miroir 72 laisse passer le premier rayonnement et réfléchisse le rayonnement émis par le bloc photoluminescent 16. Le miroir 74 peut également avoir la structure représentée sur la figure 15, les dimensions et la répartition des ouvertures 90 sont choisies pour que le miroir 72 laisse passer le rayonnement émis par le bloc photoluminescent 16 et réfléchisse le premier rayonnement.

Un mode de réalisation d'un procédé de fabrication du dispositif optoélectronique 10 représenté en figure 1 peut comprendre les étapes suivantes :
1) Formation sur la totalité d'une face du support 12 de l'empilement de couches semiconductrices formant les sources électroluminescentes 14.

Les couches semiconductrices formant les sources électroluminescentes 14 peuvent être réalisées par un procédé tel que dépôt chimique en phase vapeur (CVD) ou dépôt chimique en phase vapeur aux organométalliques (MOCVD), également connu sous le nom d'épitaxie organométallique en phase vapeur (MOVPE). Toutefois, des procédés tels que l'épitaxie par jets moléculaires (MBE), la MBE à source de gaz (GSMBE), la MBE organométallique (MOMBE), la MBE assistée par plasma (PAMBE), l'épitaxie par couche atomique (ALE) ou l'épitaxie en phase vapeur aux hydrures (HVPE) peuvent être utilisés, ainsi que le dépôt de couches atomiques (ALD) ou le dépôt en phase vapeur (PVD). En outre, des procédés tels que l'évaporation ou la pulvérisation cathodique peuvent être utilisés.

L'étape 1) peut en outre comprendre la formation d'éléments de connexion de la source électroluminescente 14 pour chaque sous-pixel d'affichage Pix.

2) Formation des cristaux photoniques 18 et des blocs photoluminescents 16.

Les blocs photoluminescents 16 peuvent être formés par le dépôt sur la structure obtenue à l'étape 1) d'une dispersion colloïdale de nanocristaux semiconducteurs dans une matrice de liaison, par exemple par un procédé dit additif. Le procédé dit additif peut comprendre l'impression directe de la dispersion colloïdale aux emplacements souhaités, par exemple par impression par jet d'encre, photogravure, sérigraphie, flexographie, revêtement par pulvérisation, revêtement par aérosol ou dépôt de gouttes. La couche 52 de chaque bloc photoluminescent 16 est ainsi obtenue. Les ouvertures 58 peuvent alors être gravées dans chaque couche 52, par exemple par des techniques de photolithographie. A titre de variante, la dispersion colloïdale comprenant les nanocristaux semiconducteurs dispersés dans la matrice de liaison peut être déposée sur la totalité de la structure obtenue à l'étape 1), les blocs photoluminescents 16 étant alors délimités par des techniques de photolithographie.

La couche 40 de chaque coupleur optique 18 peut être formée par un procédé dit additif sur la structure obtenue à l'étape 1) aux emplacements non occupés par des blocs photoluminescents 16. Les ouvertures 46 peuvent alors être gravées dans chaque couche 40, par exemple par des techniques de photolithographie.

3) Formation des murs 20 venant délimiter la source lumineuse 14 et le coupleur optique 18 pour chaque pixel d'affichage Pix. Ceci peut être obtenu en gravant des ouvertures sur la totalité de l'épaisseur des structures formées sur le support 12 aux étapes 1) et 2) aux emplacements souhaités des murs 20. La gravure mise en oeuvre peut être une gravure sèche, par exemple utilisant un plasma à base de chlore et de fluor ou une gravure par plasma à couplage inductif (ICP), une gravure ionique réactive (RIE), une gravure humide, ou une combinaison desdits procédés. Les ouvertures sont ensuite remplies avec le matériau composant les murs 20. Les murs 20 peuvent avoir une structure multicouche, le remplissage des ouvertures étant alors réalisé par des dépôts successifs.

Dans le cas où les blocs photoluminescents 16 ont la structure représentée en figure 8, l'étape 2) peut comprendre les étapes suivantes :
2a) faire croître par épitaxie sur un premier substrat l'empilement de couches semiconductrices formant les puits quantiques multiples des blocs photoluminescents du premier type sur la totalité du premier substrat ;
2b) graver l'empilement pour délimiter les blocs photoluminescents du premier type ;
2c) déposer un masque sélectif de croissance sur les blocs photoluminescents du premier type ;
2d) faire croitre par épitaxie l'empilement de couches semiconductrices formant les puits quantiques multiples des blocs photoluminescents du deuxième type entre les blocs photoluminescents du premier type ;
2e) former les ouvertures 58 dans les blocs photoluminescents du premier type et du deuxième type ;
2f) fixer, par exemple par collage moléculaire ou en utilisant un matériau de liaison, par exemple un polymère, la structure obtenue à l'étape 2e), du côté des blocs photoluminescents 16, les blocs photoluminescents du premier type et du deuxième type étant alignés avec les sous-pixels d'affichage souhaités ; et
2g) retirer le premier substrat.

Un mode de réalisation d'un procédé de fabrication du dispositif optoélectronique 70 représenté en figure 12 peut comprendre les étapes 1), 2) et 3) décrites précédemment et comprendre, entre les étapes 1) et 2), une étape de formation de la structure du miroir sélectif 72 sur la totalité de la structure obtenue à l'étape 1) et, entre les étapes 2) et 3), une étape de formation de la structure du miroir sélectif 74 sur la totalité de la structure obtenue à l'étape 2), la formation des murs 20 venant délimiter le miroir 72 et le miroir 74 pour chaque pixel d'affichage Pix.

La figure 16 est une vue en coupe, partielle et schématique, d'un autre mode de réalisation d'un dispositif optoélectronique 95. Le dispositif optoélectronique 95 comprend les mêmes éléments que le dispositif optoélectronique 10 représenté en figure 1, à la différence que le dispositif optoélectronique 95 comprend, en outre, pour chaque bloc photoluminescent du premier type, une couche 96 sensiblement transparente au deuxième rayonnement, par exemple sensiblement transparente dans le domaine visible, recouvrant le bloc photoluminescent 16 et le coupleur optique 18 qui l'entoure et à la différence que le dispositif optoélectronique 90 comprend, en outre, pour chaque bloc photoluminescent du deuxième type, une couche 98 sensiblement transparente au premier rayonnement, par exemple sensiblement transparente dans le domaine visible et ultraviolet, interposée entre, d'une part, la couche 36 et, d'autre part, le deuxième bloc photoluminescent 16 et le coupleur optique 18 qui l'entoure.

Dans le cas où chaque bloc photoluminescent 16 comprend des puits quantiques multiples, un mode de réalisation d'un procédé de fabrication du dispositif optoélectronique 95 peut comprendre les étapes 1), 2) et 3) décrites précédemment, l'étape 2) de formation des cristaux photoniques 18 et des blocs photoluminescents 16 comprenant les étapes suivantes :
4) pour les blocs photoluminescents du premier type :
   4a) faire croître par épitaxie sur un premier substrat l'empilement de couches semiconductrices formant les puits quantiques multiples des blocs photoluminescents du premier type sur la totalité du premier substrat ;
   4b) graver l'empilement pour délimiter les blocs photoluminescents du premier type ;
   4c) déposer un masque sélectif de croissance sur les blocs photoluminescents du premier type ;
   4d) faire croître la couche 98 par épitaxie sur le premier substrat entre les blocs photoluminescents du premier type ;
   4e) former les ouvertures 58 dans les blocs photoluminescents du premier type ;
   4f) fixer, par exemple par collage moléculaire ou en utilisant un matériau de liaison, par exemple un polymère, la structure obtenue à l'étape 4e), du côté des blocs photoluminescents 16 du premier type et de la couche 98, à la structure obtenue à l'étape 1), les blocs photoluminescents du premier type étant alignés avec les sous-pixels d'affichage souhaités ; et
   4g) retirer le premier substrat ;
5) pour les blocs photoluminescents du deuxième type :
   5a) faire croître par épitaxie sur un deuxième substrat l'empilement de couches semiconductrices formant les puits quantiques multiples des blocs photoluminescents du deuxième type sur la totalité du deuxième substrat ;
   5b) graver l'empilement pour délimiter les blocs photoluminescents du deuxième type ;
   5c) déposer un masque sélectif de croissance sur les blocs photoluminescents du deuxième type ;
   5d) faire croître la couche 96 par épitaxie sur le deuxième substrat entre les blocs photoluminescents du deuxième type ;
   5e) former les ouvertures 58 dans les blocs photoluminescents du deuxième type ;
   5f) fixer, par exemple par collage moléculaire ou en utilisant un matériau de liaison, par exemple un polymère, la structure obtenue à l'étape 5e), du côté des blocs photoluminescents 16 du deuxième type et de la couche 96, à la structure obtenue à l'étape 4g), les blocs photoluminescents du deuxième type étant alignés avec les sous-pixels d'affichage souhaités ; et
      5g) retirer le deuxième substrat ;
6) former les murs 20 ;
7) éventuellement retirer les portions des couches 96 et 98 présentes sur les sous-pixels qui ne comprennent pas de blocs photoluminescents.

Des modes de réalisation particuliers ont été décrits. Diverses variantes et modifications apparaîtront à l'homme de l'art. En particulier, bien que dans les modes de réalisation décrits précédemment les murs 20 aient des faces latérales qui sont sensiblement perpendiculaires aux faces 28 des sources électroluminescentes 14, les faces latérales des murs 20 peuvent être profilées, par exemple être inclinées par rapport aux faces 28. En outre, le dispositif optoélectronique peut ne comprendre, pour chaque sous-pixel d'affichage Pix, que le miroir sélectif 72 ou que le miroir sélectif 74.

## Revendications

1. Dispositif optoélectronique (10 ; 70 ; 95) comprenant :
des sources électroluminescentes (14), chaque source électroluminescente étant adaptée à émettre un premier rayonnement à une première longueur d'onde et comprenant des première et deuxième faces opposées (28, 30) ;
des blocs photoluminescents (16) répartis en premiers blocs photoluminescents adaptés à convertir par pompage optique le premier rayonnement en un deuxième rayonnement à une deuxième longueur d'onde et des deuxièmes blocs photoluminescents adaptés à convertir par pompage optique le premier rayonnement en un troisième rayonnement à une troisième longueur d'onde ; et
pour chaque bloc photoluminescent, un coupleur optique (18) comprenant un premier cristal photonique entourant au moins partiellement ledit bloc photoluminescent, le premier cristal photonique et le bloc photoluminescent recouvrant la première face (30) de l'une des sources électroluminescentes,
**caractérisé en ce que** le premier cristal photonique et le bloc photoluminescent sont à côté l'un de l'autre sur la première face, et **en ce que** le coupleur optique est adapté à modifier la direction de propagation de rayons du premier rayonnement émis par ladite source électroluminescente pour rediriger ces rayons vers ledit bloc photoluminescent.

2. Dispositif optoélectronique selon la revendication 1, dans lequel chaque coupleur optique (18) comprend une première couche (40) d'un premier matériau ayant un premier indice de réfraction à la première longueur d'onde, la première couche ayant des première et deuxième faces (42, 44) opposées, la première ou deuxième face recouvrant ladite source électroluminescente (14), chaque coupleur optique comprenant en outre des premières ouvertures (46) s'étendant dans la première couche depuis la première face et/ou la deuxième face et remplies d'un deuxième matériau ayant un deuxième indice de réfraction à la première longueur d'onde différent du premier indice de réfraction.

3. Dispositif optoélectronique selon la revendication 1 ou 2, dans lequel chaque bloc photoluminescent (16) comprend un deuxième cristal photonique adapté à laisser passer le premier rayonnement, la vitesse de propagation du premier rayonnement dans le bloc photoluminescent étant inférieure à la vitesse de propagation du premier rayonnement dans le coupleur optique (18) adjacent audit bloc photoluminescent.

4. Dispositif optoélectronique selon la revendication 3, dans lequel chaque bloc photoluminescent (16) comprend des particules monocristallines photoluminescentes (60) de taille nanométrique d'un matériau semiconducteur.

5. Dispositif optoélectronique selon la revendication 3 ou 4, dans lequel chaque bloc photoluminescent (16) comprend une deuxième couche (52) d'un troisième matériau ayant un troisième indice de réfraction à la première longueur d'onde, la deuxième couche ayant des troisième et quatrième faces (54, 56) opposées, la troisième ou quatrième face recouvrant ladite source électroluminescente (14), chaque bloc photoluminescent comprenant en outre des deuxièmes ouvertures (58) s'étendant dans la deuxième couche depuis la troisième et/ou quatrième face et remplies d'un quatrième matériau ayant un quatrième indice de réfraction à la première longueur d'onde différent du troisième indice de réfraction.

6. Dispositif optoélectronique selon la revendication 5 dans son rattachement à la revendication 4, dans lequel les particules monocristallines photoluminescentes (60) sont situées dans la deuxième couche (52) et/ou dans les deuxièmes ouvertures (58) .

7. Dispositif optoélectronique selon l'une quelconque des revendications 1 à 6, comprenant, en outre, pour chaque bloc photoluminescent (16), un premier miroir sélectif (72) interposé entre ladite source lumineuse (14) et ledit bloc photoluminescent, le premier miroir sélectif étant adapté à laisser passer le premier rayonnement et réfléchir le deuxième rayonnement et/ou le troisième rayonnement.

8. Dispositif optoélectronique selon la revendication 7, dans lequel le premier miroir sélectif (72) comprend un troisième cristal photonique.

9. Dispositif optoélectronique selon l'une quelconque des revendications 1 à 8, comprenant, en outre, pour chaque bloc photoluminescent (16), un deuxième miroir sélectif (74), ledit bloc photoluminescent (16) étant interposé entre ladite source lumineuse (14) et ledit deuxième miroir, le deuxième miroir étant adapté à réfléchir le premier rayonnement et à laisser passer le deuxième rayonnement et/ou le troisième rayonnement.

10. Dispositif optoélectronique selon l'une quelconque des revendications 1 à 9, comprenant en outre des troisièmes blocs photoluminescents adaptés à convertir par pompage optique le premier rayonnement en un quatrième rayonnement à une quatrième longueur d'onde.

11. Dispositif optoélectronique selon l'une quelconque des revendications 1 à 10, comprenant en outre des murs (20) réfléchissant les premier, deuxième et troisième rayonnements, lesdits murs séparant les sources électroluminescentes (14) et séparant les blocs photoluminescents (16).

12. Dispositif optoélectronique selon l'une quelconque des revendications 1 à 11, comprenant en outre un filtre recouvrant les blocs photoluminescents (16) du côté des blocs photoluminescents opposé aux sources électroluminescentes (14) et adapté à bloquer le premier rayonnement et à laisser passer les deuxième et troisième rayonnements.

13. Dispositif optoélectronique selon l'une quelconque des revendications 1 à 12, dans lequel les sources électroluminescentes (14) comprennent des diodes électroluminescentes ou des diodes laser à cavité verticale émettant par la surface.

14. Procédé de fabrication d'un dispositif optoélectronique (10 ; 70) selon l'une quelconque des revendications 1 à 13, comprenant les étapes suivantes :
a) former des sources électroluminescentes (14) ;
b) former des blocs photoluminescents (32) sur les sources électroluminescentes ; et
d) former des coupleurs optiques (18) sur les sources électroluminescentes, chaque coupleur optique entourant au moins partiellement l'un des blocs photoluminescents,
**caractérisé en ce que**, pour chaque bloc photoluminescent, le coupleur optique (18) comprend un premier cristal photonique entourant au moins partiellement le bloc photoluminescent correspondant,
le premier cristal photonique et le bloc photoluminescent recouvrant la première face (30) de la source électroluminescente correspondante,
le premier cristal photonique et le bloc photoluminescent étant à côté l'un de l'autre sur la première face,
le coupleur optique étant adapté à modifier la direction de propagation de rayons du premier rayonnement émis par ladite source électroluminescente pour rediriger ces rayons vers ledit bloc photoluminescent.

## Patentansprüche

1. Optoelektronische Vorrichtung (10; 70; 95), die Folgendes aufweist:
lichtemittierende Quellen (14), wobei jede lichtemittierende Quelle in der Lage ist, eine erste Strahlung mit einer ersten Wellenlänge zu emittieren, und erste und zweite gegenüberliegende Oberflächen (28, 30) aufweist;
photolumineszente Blöcke (16), die aufgeteilt sind in erste photolumineszente Blöcke, die in der Lage sind, durch optisches Pumpen die erste Strahlung in eine zweite Strahlung mit einer zweiten Wellenlänge umzuwandeln, und in zweite photolumineszente Blöcke, die in der Lage sind, durch optisches Pumpen die erste Strahlung in eine dritte Strahlung mit einer dritten Wellenlänge umzuwandeln; und
für jeden photolumineszenten Block einen optischen Koppler (18), der einen ersten photonischen Kristall aufweist, der den photolumineszenten Block zumindest teilweise umgibt, wobei der erste photonische Kristall und der photolumineszente Block die erste Oberfläche (30) einer der Lichtquellen bedecken,
**dadurch gekennzeichnet, dass** der erste photonische Kristall und der photolumineszente Block an der ersten Oberfläche nebeneinander liegen und dass der optische Koppler in der Lage ist, die Ausbreitungsrichtung der Strahlen der ersten Strahlung, die von der lichtemittierenden Quelle emittiert wird, zu verändern, um die Strahlen zu dem photolumineszenten Block umzulenken.

2. Optoelektronische Vorrichtung nach Anspruch 1, wobei jeder optische Koppler (18) eine erste Schicht (40) aus einem ersten Material mit einem ersten Brechungsindex bei der ersten Wellenlänge aufweist, wobei die erste Schicht eine erste und eine zweite gegenüberliegende Oberfläche (42, 44) aufweist, wobei die erste oder die zweite Oberfläche die lichtemittierende Quelle (14) bedeckt, wobei jeder optische Koppler ferner erste Öffnungen (46) aufweist, die sich in der ersten Schicht von der ersten Oberfläche und/oder der zweiten Oberfläche aus erstrecken und mit einem zweiten Material gefüllt sind, das einen zweiten Brechungsindex bei der ersten Wellenlänge aufweist, der sich von dem ersten Brechungsindex unterscheidet.

3. Optoelektronische Vorrichtung nach Anspruch 1 oder 2, wobei jeder photolumineszente Block (16) einen zweiten photonischen Kristall aufweist, der in der Lage ist, die erste Strahlung durchzulassen, wobei die Ausbreitungsgeschwindigkeit der ersten Strahlung in dem photolumineszenten Block kleiner ist als die Ausbreitungsgeschwindigkeit der ersten Strahlung in dem optischen Koppler (18), der benachbart zum photolumineszenten Block liegt.

4. Optoelektronische Vorrichtung nach Anspruch 3, wobei jeder photolumineszente Block (16) photolumineszente Einkristallpartikel (60) aus einem Halbleitermaterial im Nanometerbereich aufweist.

5. Optoelektronische Vorrichtung nach Anspruch 3 oder 4, wobei jeder photolumineszente Block (16) eine zweite Schicht (52) aus einem dritten Material mit einem dritten Brechungsindex bei der ersten Wellenlänge aufweist, wobei die zweite Schicht dritte und vierte gegenüberliegende Oberflächen (54, 56) aufweist, wobei die dritte oder vierte Oberfläche die lichtemittierende Quelle (14) bedeckt, wobei jeder Photolumineszente Block außerdem zweite Öffnungen (58) aufweist, die sich in der zweiten Schicht von der dritten und/oder vierten Oberfläche aus erstrecken und mit einem vierten Material gefüllt sind, das einen vierten Brechungsindex bei der ersten Wellenlänge aufweist, der sich von dem dritten Brechungsindex unterscheidet.

6. Optoelektronische Vorrichtung nach Anspruch 5 und nach Anspruch 4, wobei die photolumineszenten Einkristallpartikel (60) in der zweiten Schicht (52) und/oder in den zweiten Öffnungen (58) angeordnet sind.

7. Optoelektronische Vorrichtung nach einem der Ansprüche 1 bis 6, die ferner für jeden photolumineszenten Block (16) einen ersten selektiven Spiegel (72) aufweist, der zwischen der Lichtquelle (14) und dem photolumineszenten Block angeordnet ist, wobei der erste selektive Spiegel in der Lage ist, die erste Strahlung durchzulassen und die zweite Strahlung und/oder die dritte Strahlung zu reflektieren.

8. Optoelektronische Vorrichtung nach Anspruch 7, wobei der erste selektive Spiegel (72) einen dritten photonischen Kristall aufweist.

9. Optoelektronische Vorrichtung nach einem der Ansprüche 1 bis 8, die ferner für jeden photolumineszenten Block (16) einen zweiten selektiven Spiegel (74) aufweist, wobei der photolumineszente Block (16) zwischen der Lichtquelle (14) und dem zweiten Spiegel angeordnet ist und der zweite Spiegel in der Lage ist, die erste Strahlung zu reflektieren und die zweite Strahlung und/oder die dritte Strahlung durchzulassen.

10. Optoelektronische Vorrichtung nach einem der Ansprüche 1 bis 9, die ferner dritte photolumineszente Blöcke aufweist, die in der Lage sind, durch optisches Pumpen die erste Strahlung in eine vierte Strahlung mit einer vierten Wellenlänge umzuwandeln.

11. Optoelektronische Vorrichtung nach einem der Ansprüche 1 bis 10, die ferner Wände (20) aufweist, die die erste, zweite und dritte Strahlung reflektieren, wobei die Wände die lichtemittierenden Quellen (14) und die photolumineszenten Blöcke (16) voneinander trennen.

12. Optoelektronische Vorrichtung nach einem der Ansprüche 1 bis 11, die ferner einen Filter aufweist, der die photolumineszenten Blöcke (16) auf der den Lichtquellen (14) gegenüberliegenden Seite der photolumineszenten Blöcke abdeckt und in der Lage ist, die erste Strahlung zu blockieren und die zweite und dritte Strahlung durchzulassen.

13. Optoelektronische Vorrichtung nach einem der Ansprüche 1 bis 12, wobei die lichtemittierenden Quellen (14) lichtemittierende Dioden oder oberflächenemittierende Laserdioden mit vertikalem Resonator aufweisen.

14. Verfahren zur Herstellung der optoelektronischen Vorrichtung (10; 70) nach einem der Ansprüche 1 bis 13, wobei das Verfahren die folgenden Schritte aufweist:
a) Ausbilden der lichtemittierenden Quellen (14);
b) Ausbilden der photolumineszenten Blöcke (32) auf den lichtemittierenden Quellen; und
d) Ausbilden der optischen Koppler (18) auf den lichtemittierenden Quellen, wobei jeder optische Koppler zumindest teilweise einen der photolumineszenten Blöcke umgibt,
**dadurch gekennzeichnet, dass** der optische Koppler (18) für jeden photolumineszenten Block einen ersten photonischen Kristall aufweist, der diesen photolumineszenten Block zumindest teilweise umgibt,
der erste photonische Kristall und der photolumineszente Block die erste Oberfläche (30) der entsprechenden lichtemittierenden Quelle bedecken,
der erste photonische Kristall und der photolumineszente Block auf der ersten Oberfläche nebeneinander liegen,
wobei der optische Koppler in der Lage ist, die Ausbreitungsrichtung der Strahlen der ersten Strahlung, die von der Lichtquelle emittiert wird, zu ändern, um die Strahlen in Richtung des photolumineszenten Blocks umzulenken.

## Claims

1. An optoelectronic device (10; 70; 95) comprising:
light-emitting sources (14), each light-emitting source being capable of emitting a first radiation at a first wavelength and comprising first and second opposite surfaces (28, 30);
photoluminescent blocks (16) distributed into first photoluminescent blocks capable of converting by optical pumping the first radiation into a second radiation at a second wavelength and second photoluminescent blocks capable of converting by optical pumping the first radiation into a third radiation at a third wavelength; and
for each photoluminescent block, an optical coupler (18) comprising a first photonic crystal at least partially surrounding said photoluminescent block, the first photonic crystal and the photoluminescent block covering the first surface (30) of one of the light-emitting sources,
**characterized in that** the first photonic crystal and the photoluminescent block are next to each other on the first surface, and **in that** the optical coupler is capable of modifying the propagation direction of rays of the first radiation emitted by said light-emitting source to redirect the rays towards said photoluminescent block.

2. The optoelectronic device of claim 1, wherein each optical coupler (18) comprises a first layer (40) of a first material having a first refraction index at the first wavelength, the first layer having first and second opposite surfaces (42, 44), the first or second surface covering said light-emitting source (14), each optical coupler further comprising first openings (46) extending in the first layer from the first surface and/or the second surface and filled with a second material having a second refraction index at the first wavelength different from the first refraction index.

3. The optoelectronic device of claim 1 or 2, wherein each photoluminescent block (16) comprises a second photonic crystal capable of letting passing the first radiation, the propagation speed of the first radiation in the photoluminescent block being smaller than the propagation speed of the first radiation in the optical coupler (18) adjacent to said photoluminescent block.

4. The optoelectronic device of claim 3, wherein each photoluminescent block (16) comprises nanometer-range photoluminescent single-crystal particles (60) of a semiconductor material.

5. The optoelectronic device of claim 3 or 4, wherein each photoluminescent block (16) comprises a second layer (52) of a third material having a third refraction index at the first wavelength, the second layer having third and fourth opposite surfaces (54, 56), the third or fourth surface covering said light-emitting source (14), each photoluminescent block further comprising second openings (58) extending in the second layer from the third and/or fourth surface and filled with a fourth material having a fourth refraction index at the first wavelength different from the third refraction index.

6. The optoelectronic device of claim 5 and of claim 4, wherein the light-emitting single-crystal particles (60) are located in the second layer (52) and/or in the second openings (58) .

7. The optoelectronic device of any of claims 1 to 6, further comprising, for each photoluminescent block (16), a first selective mirror (72) interposed between said light source (14) and said photoluminescent block, the first selective mirror being capable of letting pass the first radiation and of reflecting the second radiation and/or the third radiation.

8. The optoelectronic device of claim 7, wherein the first selective mirror (72) comprises a third photonic crystal.

9. The optoelectronic device of any of claims 1 to 8, further comprising, for each photoluminescent block (16), a second selective mirror (74), said photoluminescent block (16) being interposed between said light source (14) and said second mirror, the second mirror being capable of reflecting the first radiation and of letting pass the second radiation and/or the third radiation.

10. The optoelectronic device of any of claims 1 to 9, further comprising third photoluminescent blocks capable of converting by optical pumping the first radiation into a fourth radiation at a fourth wavelength.

11. The optoelectronic device of any of claims 1 to 10, further comprising walls (20) reflecting the first, second, and third radiations, said walls separating the light-emitting sources (14) and separating the photoluminescent blocks (16).

12. The optoelectronic device of any of claims 1 to 11, further comprising a filter covering the photoluminescent blocks (16) on the side of the photoluminescent blocks opposite to the light-emitting sources (14) and capable of blocking the first radiation and of letting pass the second and third radiations.

13. The optoelectronic device of any of claims 1 to 12, wherein the light-emitting sources (14) comprise light-emitting diodes or vertical cavity surface-emitting laser diodes.

14. A method of manufacturing the optoelectronic device (10; 70) of any of claims 1 to 13, comprising the steps of:
a) forming the light-emitting sources (14);
b) forming the photoluminescent blocks (32) on the light-emitting sources; and
d) forming the optical couplers (18) on the light-emitting sources, each optical coupler at least partially surrounding one of the photoluminescent blocks,
**characterized in that**, for each photoluminescent block, the optical coupler (18) comprises a first photonic crystal at least partially surrounding said photoluminescent block,
the first photonic crystal and the photoluminescent block covering the first surface (30) of the corresponding light-emitting source,
the first photonic crystal and the photoluminescent block being next to each other on the first surface,
the optical coupler being capable of modifying the propagation direction of rays of the first radiation emitted by said light-emitting source to redirect the rays towards said photoluminescent block.
